# EUROPÄISCHE PATENTSCHRIFT

(11) **EP 2 410 235 B1**
(45) Veröffentlichungstag und Bekanntmachung des Hinweises auf die Patenterteilung: **19.07.2017**
(21) Anmeldenummer: 11175025.3
(22) Anmeldetag: 22.07.2011
(51) Int. Cl.: F21V 14/00, H01L 51/50, H01L 51/52, F21S 8/04, F21S 8/06, F21Y 105/00, F21Y 115/15

(54) **OLED Leuchte**
OLED light
Lampe OLED

(30) Priorität: 23.07.2010 DE 102010038363
(43) Veröffentlichungstag der Anmeldung: 25.01.2012
(73) Patentinhaber: Trilux GmbH & Co. KG, 59759 Arnsberg (DE)
(72) Erfinder: Rudolph, Horst, 59067 Hamm (DE); Gretenkort, Sebastian, 59469 Ense (DE)
(74) Vertreter: Lippert Stachow Patentanwälte Rechtsanwälte

(56) Entgegenhaltungen:
- WO-A1-2010/004489
- DE-A1-102008 027 909
- DE-B3-102008 012 383
- US-A1- 2008 062 707

## Beschreibung

Die Erfindung betrifft eine Leuchte mit organischen Leuchtdioden (OLED), die dazu eingerichtet ist, auf einfache Weise Intensität und Richtung des abgestrahlten Lichts zu verändern.

OLED können mit relativ hohem Wirkungsgrad elektrische Energie in Licht umwandeln. Sie sind meist aus mehreren organischen Schichten aufgebaut, darunter eine Elektronen leitende Emitterschicht und eine Löcher (Defektelektronen) leitende Schicht. Außerdem sind Elektrodenschichten zur Injektion der Elektronen und Löcher in die organischen Schichten vorhanden. Durch Rekombination von Elektronen und Löchern werden in den organischen Schichten über Zwischenstufen Photonen erzeugt. Infolge der stürmischen Entwicklung auf dem Gebiet der OLED könnten diese schon bald wirtschaftlich für allgemeine Beleuchtung eingesetzt werden. Sie lassen sich großflächig herstellen und geben dann ein diffuses, angenehmes Licht mit geringer Schattenbildung und Blendung. Da die Licht emittierenden Schichten und die Elektrodenschichten aus wirtschaftlichen und technischen Gründen relativ dünn gehalten werden, versieht man die OLED-Anordnung meist noch mit flexiblen Schutzschichten oder auch starren Trägern.

Die Intensitätsverteilung des von einer flächigen OLED abgestrahlten Lichts gehorcht im allgemeinen dem Lambertschen Kosinusgesetz. Dabei ist für jedes Flächenelement die Intensität der Strahlung proportional den Kosinus des Winkels gegen die Flächennormale. In c't-magazin, 2007, Heft 16, Seiten 82 ff. ist die Wirkungsweise von OLED beispielhaft beschrieben.

Damit das Licht aus den organischen Schichten in die Umgebung austreten kann, muss wenigstens eine der Elektrodenschichten lichtdurchlässig sein. Solche Schichten lassen sich in bekannter Weise beispielsweise aus Indium-Zinn-Oxid (ITO) herstellen, während ebenfalls infrage kommende Metallschichten lichtundurchlässig sind. Je nachdem, ob eine oder beide der Elektrodenschichten und ggf. der Träger lichtdurchlässig sind, strahlt die OLED-Anordnung Licht nur in einen Halbraum oder nach beiden Seiten aus. Man spricht auch von intransparenten beziehungsweise transparenten OLED.

Bei der Anwendung von OLED bei Leuchten, beispielsweise für Arbeits- oder Wohnbereiche, ist es erwünscht, dass die Leuchte neben der diffusen Lambert-Strahlung auch eine gerichtete oder fokussierte Strahlung abgeben kann. Dadurch könnte man beispielsweise mit einer Leuchte sowohl eine ausreichende Allgemeinbeleuchtung als auch eine dem jeweiligen Zweck entsprechende selektive Beleuchtung eines Arbeitsbereiches erzielen. Zu einer solchen selektiven Beleuchtung schlägt die DE 10 2008 027 909 A1 vor, auf der Fläche eines Leuchtdioden-Arrays einzeln ansteuerbare Gebiete vorzusehen und die Leuchtenfläche mit einer Optik, beispielsweise einer Fresnellinse, auf dem Arbeitsbereich abzubilden.

DE 10 2008 012 383 B3 beschreibt ein Licht erzeugendes Wandelement mit zwei scheibenförmigen beabstandeten transparenten Substraten zur Verwendung als Fenster, wobei das zum Innenraum weisende Substrat mit einer transparenten OLED-Anordnung versehen ist und das andere Substrat mit einer Schicht versehen sein kann, welche nach außen abgedunkelt werden und/oder das von der OLED erzeugte Licht in den Raum zurück reflektieren kann. Eine solche Schicht kann eine elektrochrome oder gasochrome Schicht oder eine schaltbare Spiegelschicht sein. WO2010/004489A1 beschreibt eine Leuchte gemäß dem Oberbegriff des Anspruchs 1. Die Erfindung stellt sich die Aufgabe, eine Leuchte mit einer OLED, insbesondere zur Verwendung als Wand-, Decken- oder Hängeleuchte zu schaffen, mit der sowohl diffuses als auch gerichtetes und fokussiertes Licht erzeugt werden kann, wobei diese Beleuchtungsarten auf einfache Weise flexibel an die jeweiligen Bedürfnisse angepasst werden können.

Diese Aufgabe wird gelöst durch eine Leuchte nach dem Hauptanspruch.

Der Träger dient als Stütze für die OLED-Anordnung. Außerdem trägt er die Mittel zur Befestigung der Leuchte an einer Aufhänge- oder Haltevorrichtung oder an einer Wand oder Decke. Diese Mittel können zum Beispiel Bohrungen für Befestigungsschrauben, Stäbe oder Drähte, Rahmen, Gehäuse oder dergleichen sein. Wenn die Leuchte in beide Halbräume strahlen soll, ist der Träger transparent, beispielsweise aus Glas oder Kunststoff. Bevorzugt besteht der Träger aus einem starren Material, weil die Leuchte sich dann ohne Stützkonstruktion selbst trägt und weil als Licht modulierende Elemente, die mit der OLED-Anordnung in Kontakt stehen sollen, ohnehin hauptsächlich steife Glas- oder Kunststoffkörper in Frage kommen.

Das Licht modulierende Element ist eine Schicht oder ein plattenförmiger Körper, welcher die Intensität und/oder die Richtung des darauf fallenden Lichts verändern kann. Es ist schaltbar, das heißt, dass die Veränderung der Intensität und/oder der Richtung mittels eines elektrischen Signals eingestellt werden kann, bevorzugt stufenlos kontinuierlich. Das Licht modulierende Element wird im Kontakt mit der OLED-Anordnung und/oder dem transparenten Träger angeordnet.

Die OLED-Anordnung umfasst ein Schichtsystem aus organischen niedermolekularen oder polymeren Substanzen, die für die Erzeugung von Licht geeignet sind. Auf beiden Seiten dieses Schichtpaketes sind Elektrodenschichten angebracht, von denen mindestens eine transparent ist. Materialien für transparente Elektrodenschichten sind beispielsweise Indium-Zinn-Oxid oder aluminiumdotiertes Zinkoxid, welches direkt auf die OLED-Anordnung abgeschieden wird, für intransparente Elektroden eignen sich Metalle wie Aluminium, Silber, auch Seltenerdmetalle, die ebenfalls direkt auf die OLED-Anordnung abgeschieden werden oder als Substrat der OLED-Anordnung als Träger dienen. Gemäß der Erfindung werden die Licht modulierenden Elemente als separat gekapselte Schichten mit transparenten oder intransparenten OLED kombiniert. Bevorzugt dient als Licht modulierendes Element zur Beeinflussung der Intensität ein elektrochromes Glas oder ein LC-Glas. Solche an sich bekannten Gläser ändern ihre Transmission, wenn mittels transparenter Elektroden eine elektrische Spannung senkrecht zur Glasebene angelegt wird. Elektrochrome Gläser umfassen beispielsweise Schichten aus Metalloxiden wie Wolframoxid oder aus bestimmten Polymeren wie Polyanilin. LC-Gläser umfassen mindestens eine Schicht mit einem Flüssigkristall, die ohne angelegte Spannung opak ist und beim Anlegen einer Spannung infolge Ausrichtung ihrer Moleküle transparent wird.

In einer weiteren vorteilhaften Ausgestaltung umfasst das Licht modulierende Element ein Mikrospiegelarray. Dabei handelt es sich um eine matrixförmige Anordnung aus mikroskopisch kleinen kippbaren Spiegeln, deren Stellung einzeln durch entsprechende elektrische Signale verändert werden kann. Solche Mikrospiegelarrays sind an sich bekannt und werden beispielsweise in digitalen Projektoren (Beamern) verwendet. Sie werden auch als Mikrospiegelaktoren oder DMD bezeichnet und gehören zu den mikroelektromechanischen Systemen (MEMS). Durch ein geeignetes elektrisches Signal können die Mikrospiegel so ausgerichtet werden, dass sie das auftreffende Licht parallel in die gleiche Richtung reflektieren oder auch auf einem gemeinsamen Brennpunkt hin fokussieren. "Ausrichten" und "Fokussieren" ist hier so zu verstehen, daß eine gewisse Vorzugsrichtung bzw. Sammlung des Lichts stattfindet, weil das auf die Mikrospiegel fallende Licht nicht parallel ausgerichtet ist. Zur Arbeitsplatzbeleuchtung kann dies aber durchaus erwünscht sein.

Das elektrochrome oder LC-Glas oder das Mikrospiegelarray ist vorzugsweise in Teilbereiche segmentiert, die einzeln ansteuerbar sind.

Die Licht modulierenden Elemente können so angesteuert werden, daß sie eine Entblendung der OLED-Lichtquelle hinsichtlich eines vorgegebenen Arbeitsplatzes bewirken.

Wenn die Halbräume zu beiden Seiten der Leuchte beleuchtbar sein sollen, wird vorteilhaft eine transparente OLED eingesetzt. Diese kann auf einer Seite mit einem Licht modulierenden Element oder auf beiden Seiten mit gleichen oder verschiedenen Licht modulierenden Elementen versehen sein. So ist es beispielsweise möglich, eine Hängeleuchte bereitzustellen, die auf der zur Raumdecke weisenden Seite kein Licht modulierendes Element aufweist und daher als Lambert-Strahler über die Raumdecke eine diffuse Raumbeleuchtung schafft, während die nach unten zum Rauminneren weisende Seite ganz oder teilweise mit einem Mikrospiegelarray belegt ist und einen oder mehrere Arbeitsbereiche gerichtet beziehungsweise fokussiert beleuchten kann. Eine andere Ausführungsform kann beispielsweise auf der zur Decke weisenden Seite ebenfalls ein Licht modulierendes Element aufweisen. Wenn dies ein elektrochromes Glas ist, kann die diffuse Raumbeleuchtung abgedunkelt werden. Mit einem Mikrospiegelarray kann sowohl eine Dämpfung der diffusen Raumbeleuchtung als auch eine Verstärkung der in den Innenraum abgegebenen Lichtstrahlung erreicht werden.

Soll nur ein Halbraum beleuchtbar sein, wie es insbesondere auf Wand- oder Deckenleuchten zutrifft, kann eine Leuchte mit intransparenter OLED verwendet werden. Insbesondere wenn die intransparente Elektrodenschicht eine reflektierende Metallschicht ist, wird dann das gesamte erzeugte Licht in einen Halbraum abgegeben. Auf der Licht abstrahlenden Seite der Leuchte ist aber erfindungsgemäß ebenfalls mindestens ein Licht modulierendes Element vorgesehen.

Erfindungsgemäß ist es auch möglich, auf mindestens einer Seite der OLED-Anordnung mehrere, beispielsweise zwei, übereinander angeordnete Licht modulierende Elemente vorzusehen.

Bei einer weiteren erfindungsgemäßen Ausführungsform sind auf mindestens einer Licht emittierenden Seite der Leuchte unterschiedliche Licht modulierende Elemente nebeneinander angeordnet. Dies kann beispielsweise ein elektrochromes oder LC-Glas neben einem Mikrospiegelarray sein. Dadurch kann mit einer Leuchte sowohl eine diffuse dimmbare Raumbeleuchtung als auch eine gerichtete beziehungsweise fokussierte Arbeitsplatzbeleuchtung geschaffen werden.

Erfindungsgemäß bevorzugte Ausführungsformen sind beispielsweise:
1. Decken- oder Wandleuchte mit intransparenter OLED und Mikrospiegelarray unterhalb der Lichtaustrittsfläche zur definierten Lenkung des lambertsch von der OLED abgestrahlten Lichts;
2. Hängeleuchte mit transparenter OLED und unterhalb angebrachtem Mikrospiegelarray zur Ausrichtung des von der OLED lambertsch nach unten abgestrahlten Lichts;
3. Hängeleuchte mit transparenter OLED und unterhalb angebrachtem Mikrospiegelarray, kombiniert mit unterhalb angebrachtem elektrochromem Glas;
4. Hängeleuchte mit transparenter OLED und oberhalb angebrachtem Mikrospiegelarray;
5. Hängeleuchte mit transparenter OLED und oberhalb angebrachtem Mikrospiegelarray, kombiniert mit oberhalb angebrachtem elektrochromem Glas;
6. Hängeleuchte mit transparenter OLED und oberhalb und unterhalb angebrachten Mikrospiegelarrays;
7. Hängeleuchte mit transparenter OLED und oben und unten angebrachten Mikrospiegelarrays, kombiniert mit oben und unten angebrachtem elektrochromem Glas.

Die Erfindung wird nun anhand der beigegebenen Zeichnungen beispielhaft näher erläutert. Es zeigen
Figur 1 eine erfindungsgemäße Hängeleuchte nach einer ersten Ausführungsform,
Figur 2 eine erfindungsgemäße Hängeleuchte nach einer zweiten Ausführungsform,
Figur 3 eine erfindungsgemäße Deckenleuchte,
Figur 4 eine erfindungsgemäße Hängeleuchte nach einer dritten Ausführungsform,
Figuren 5a, b, c eine erfindungsgemäße Hängeleuchte nach einer vierten Ausführungsform in unterschiedlichen Betriebszuständen.

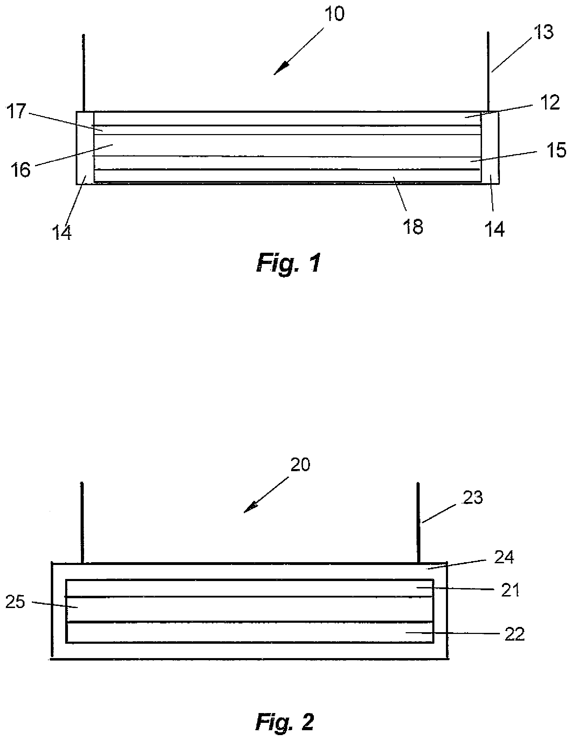

Die in Figur 1 gezeigte Hängeleuchte 10 umfasst eine OLED-Anordnung und im Kontakt mit dieser ein Licht modulierendes Element 12. Die OLED-Anordnung umfasst zumindest eine transparente Katodenschicht 15, organische Licht emittierende Schichten 16 sowie eine transparente Anodenschicht 17, das heißt, es handelt sich um eine transparente OLED-Anordnung. Außerdem ist an der Unterseite zum Schutz der OLED-Anordnung eine transparente Abdeckung 18 angebracht. Diese Leuchtenanordnung ist an den Seiten von einem rahmenartigen starren Träger 14 umgeben. An beiden Enden der Leuchte befinden sich Seile 13 zum Aufhängen an der Decke, die durch hier nicht gezeigte Befestigungsmittel mit dem Träger 14 verbunden sind. Auf ihrer Oberseite steht die OLED-Anordnung in Kontakt mit einem elektrochromen Glas 12 als Licht modulierendem Element. Betriebsmittel wie Vorschaltgerät oder Netzgerät und Steuereinheit für die Steuerung des Licht modulierenden Elements sowie die entsprechenden Verbindungsleitungen sind hier nicht gezeigt, weil für den Fachmann offensichtlich. Diese Leuchte kann nun so betrieben werden, dass sie in beide Halbräume nach oben und unten diffuses Licht abstrahlt. Alternativ kann durch Ansteuern des elektrochromen Glases das nach oben gerichtete Licht im Glas zurückgestreut werden, so dass der Raum über der Leuchte dunkel bleibt.

Figur 2 zeigt eine weitere Ausführungsform einer erfindungsgemäßen Hängeleuchte 20 mit einer transparenten OLED-Anordnung 21, einem Licht modulierenden Element 22 auf der Unterseite, diesmal in Form eines Mikrospiegelarrays, einem diese ganze Anordnung umgebenden traansparenten Träger 24 und mit an diesem befestigten Seilen 23. Zwischen dem Mikrospiegelarray 22 und der OLED-Anordnung 21 ist als weiteres Licht modulierendes Element ein LC-Glas 25 angebracht. Diese Anordnung ermöglicht es, durch Ansteuern des Mikrospiegelarrays 22 das von der OLED-Schicht ausgesandte Licht nach oben oder, ggf. gerichtet, nach unten zu leiten und dabei mittels des LC-Glases mehr oder weniger abzuschwächen.

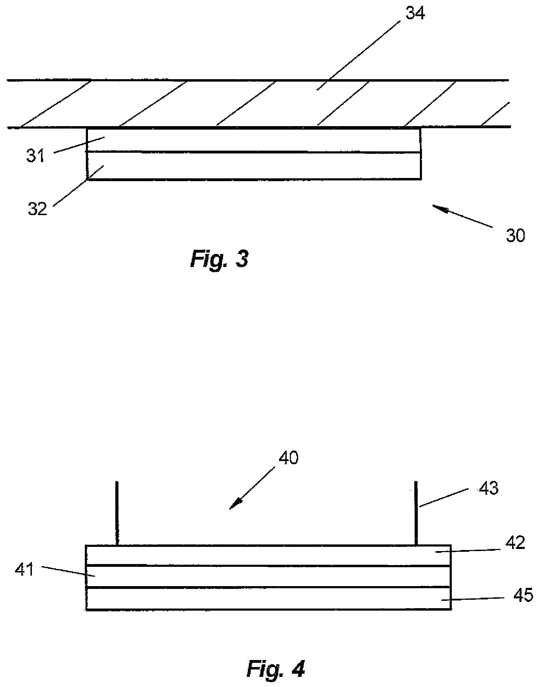

Figur 3 zeigt eine erfindungsgemäße Deckenleuchte 30, die eine intransparente OLED-Anordnung 31 sowie ein Mikrospiegelarray 32 umfasst und mit hier nicht gezeigten Mitteln auf einer Raumdecke 34 befestigt ist. Durch Ansteuern des Mikrospiegelarrays 32 lässt sich das von der OLED-Anordnung abgegebene Licht ausrichten, beispielsweise nach rechts oder links. Wenn die Spiegel so angesteuert sind, dass sie senkrecht zur Leuchtenfläche stehen, erhält man näherungsweise einen Lambert-Strahler.

Die in Figur 4 gezeigte erfindungsgemäße Hängeleuchte 40 umfasst eine transparente OLED-Anordnung 41, Seile 43, sowie eine Schicht aus elektrochromem Glas 42 auf der Oberseite und ein Mikrospiegelarray 45 auf der Unterseite. Mit dieser Leuchte ist es möglich, nach oben eine regelbare diffuse Raumbeleuchtung abzugeben und gleichzeitig einen oder gar mehrere Arbeitsplätze gerichtet zu beleuchten.

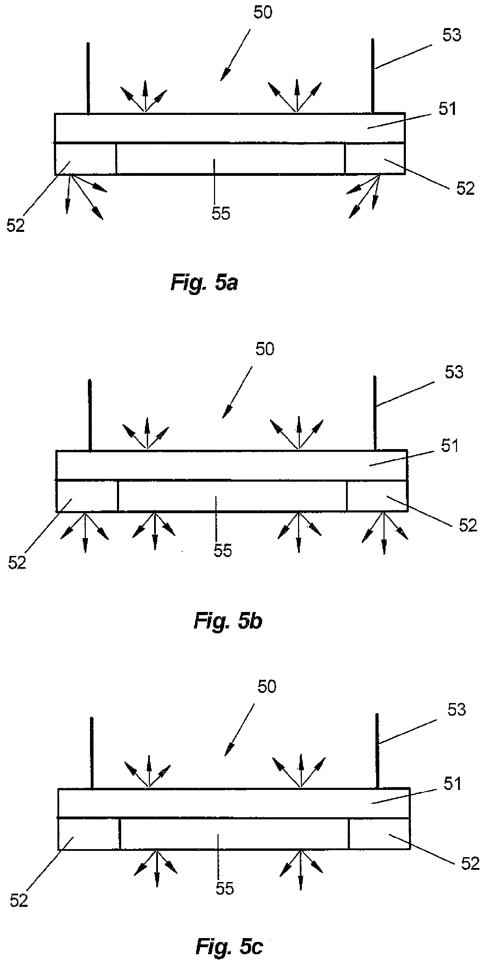

Die Figuren 5a, 5b und 5c zeigen eine weitere Ausführungsform einer erfindungsgemäßen Hängeleuchte. Diese Leuchte 50 umfasst eine transparente OLED-Anordnung 51 sowie auf der Unterseite dieser Anordnung Bereiche 52 mit Mikrospiegelarrays und einen die Mikrospiegelarrays verbindenden Bereich 55 mit elektrochromem Glas. Die eingetragenen Pfeile beschreiben die Richtung des von der Leuchte ausgehenden Lichts. Figur 5a zeigt den Zustand, bei dem die Mikrospiegelarrays 52 auf zirka 45° zur Fläche der OLED eingestellt sind und so das aus den entsprechenden Bereichen der OLED-Anordnung austretende Licht zur Mitte unter der Leuchte lenken. Dabei ist das elektrochrome Glas 55 voll angesteuert und streut Licht nur nach oben. Dabei verstärkt es die zur Decke gerichtete Lambert-Strahlung.

In Figur 5b sind die Mikrospiegelarrays auf 90° zum OLED eingestellt, so dass dessen Strahlung so gut wie unbeeinflusst hindurchtreten kann, und das elektrochrome Glas ist auf Transparenz gesteuert. In diesem Zustand verhält sich die Leuchte annähernd wie eine transparente OLED-Anordnung ohne weitere Bauteile.

Schließlich sind in Figur 5c die Mikrospiegelarrays auf 0° zur OLED-Fläche eingestellt und reflektieren daher auch die nach unten gerichtete Strahlung nach oben. Das elektrochrome Glas ist auf Transparenz gesteuert. Dadurch gelangt der größere Teil des von der OLED-Anordnung emittierten Lichts zur indirekten diffusen Raumbeleuchtung an die Decke und ein kleinerer Teil dient der direkten diffusen Beleuchtung.

### Bezugszeichenliste

- 10: Hängeleuchte
- 12: Licht modulierendes Element (elektrochromes Glas)
- 13: Seil
- 14: transparenter Träger
- 15: Katode
- 16: Licht emittierende Schicht
- 17: Anode
- 18: transparente Abdeckung
- 20: Hängeleuchte
- 21: OLED-Anordnung
- 22: Licht modulierendes Element (Mikrospiegelarray)
- 23: Seil
- 24: Träger
- 25: LC-Glas
- 30: Deckenleuchte
- 31: OLED-Anordnung
- 32: Mikrospiegelarray
- 34: Decke
- 40: Hängeleuchte
- 41: OLED-Anordnung
- 42: elektrochromes Glas
- 43: Seil
- 45: Mikrospiegelarray
- 50: Hängeleuchte
- 51: OLED-Anordnung
- 52: Mikrospiegelarray
- 53: Seil
- 55: elektrochromes Glas

## Patentansprüche

1. Leuchte, umfassend
- mindestens eine OLED-Anordnung mit einem Träger, mindestens zwei Elektrodenschichten und organischer Licht emittierender Schicht,
- mindestens einem Licht modulierenden Element, sowie
- Mitteln zur Befestigung an einer Aufhänge- oder Haltevorrichtung oder an einer Wand oder Decke, **dadurch gekennzeichnet, dass**
das Licht modulierende Element in Kontakt mit der OLED-Anordnung steht und die Licht modulierenden Elemente als separat gekapselte Schichten mit transparenten oder intransparenten OLED kombiniert sind.

2. Leuchte nach Anspruch 1, **dadurch gekennzeichnet, dass** mindestens ein Licht modulierendes Element ein elektrochromes Glas oder ein LC-Glas umfasst.

3. Leuchte nach Anspruch 2, **dadurch gekennzeichnet, dass** das elektrochrome oder LC-Glas in Teilbereiche segmentiert ist, die einzeln ansteuerbar sind.

4. Leuchte nach einem der Ansprüche 1 bis 3, **dadurch gekennzeichnet, dass** mindestens ein Licht modulierendes Element ein Mikrospiegelarray umfasst.

5. Leuchte nach Anspruch 4, **dadurch gekennzeichnet, dass** das Mikrospiegelarray in Teilbereiche segmentiert ist, die einzeln ansteuerbar sind.

6. Leuchte nach einem der vorangehenden Ansprüche, **dadurch gekennzeichnet, dass** die OLED-Anordnung eine transparente OLED-Anordnung ist.

7. Leuchte nach einem der vorangehenden Ansprüche 1 oder 2, **dadurch gekennzeichnet, dass** die OLED-Anordnung eine intransparente OLED-Anordnung ist.

8. Leuchte nach einem der vorangehenden Ansprüche, **dadurch gekennzeichnet, dass** auf mindestens einer Seite der OLED-Anordnung mehrere Licht modulierende Elemente übereinander angeordnet sind.

9. Leuchte nach einem der vorangehenden Ansprüche, **dadurch gekennzeichnet, dass** auf mindestens einer Licht emittierenden Seite der OLED-Anordnung unterschiedliche Licht modulierende Elemente nebeneinander angebracht sind.

10. Leuchte nach Anspruch 6, **dadurch gekennzeichnet, dass** auf beiden Seiten der OLED-Anordnung Licht modulierende Elemente angebracht sind.

11. Leuchte nach Anspruch 7, **dadurch gekennzeichnet, dass** die Licht modulierenden Elemente auf beiden Seiten unterschiedlich sind.

## Claims

1. A luminaire, comprising
- at least one OLED arrangement with a carrier, at least two electrode layers and an organic light-emitting layer,
- at least one light-modulating element, as well as
- means for fixing to a suspension or holding apparatus or to a wall or ceiling,
**characterized in that**
the light-modulating element is in contact with the OLED arrangement, and the light-modulating elements are combined as separately encapsulated layers with transparent or non-transparent OLED.

2. A luminaire according to claim 1, **characterized in that** at least one light-modulating element comprises an electrochromic glass or an LC glass.

3. A luminaire according to claim 2, **characterized in that** the electrochromic or LC glass is segmented into sections which can be triggered individually.

4. A luminaire according to one of claims 1 to 3, **characterized in that** at least one light-modulating element comprises a micromirror array.

5. A luminaire according to claim 4, **characterized in that** the micromirror array is segmented into sections which can be triggered individually.

6. A luminaire according to one of the preceding claims, **characterized in that** the OLED arrangement is a transparent OLED arrangement.

7. A luminaire according to one of the preceding claims 1 or 2, **characterized in that** the OLED arrangement is a non-transparent OLED arrangement.

8. A luminaire according to one of the preceding claims, **characterized in that** a plurality of light-modulating elements are arranged one above the other on at least one side of the OLED arrangement.

9. A luminaire according to one of the preceding claims, **characterized in that** different light-modulating elements are mounted side by side on at least one light-emitting side of the OLED arrangement.

10. A luminaire according to claim 6, **characterized in that** light-modulating elements are attached to both sides of the OLED arrangement.

11. A luminaire according to claim 7, **characterized in that** the light-modulating elements are different on both sides.

## Revendications

1. Lampe comprenant
- au moins une disposition d'OLED avec un support, au moins deux couches d'électrodes et une couche luminescente organique,
- au moins un élément modulant la lumière et
- des moyens de fixation sur un dispositif de suspension
ou de maintien ou sur un mur ou un plafond, **caractérisée en ce que** l'élément modulant la lumière est en contact avec la disposition d'OLED et les éléments modulant la lumière sont combinés avec des OLED transparentes ou non transparentes en couches encapsulées séparément.

2. Lampe selon la revendication 1, **caractérisée en ce qu'**au moins un élément modulant la lumière est un verre électrochromatique ou un verre LC.

3. Lampe selon la revendication 2, **caractérisée en ce que** le verre électrochromatique ou LC est segmenté en zones qui peuvent être activées séparément.

4. Lampe selon l'une des revendications 1 à 3, **caractérisée en ce qu'**au moins un élément modulant la lumière comprend une matrice de micromiroirs.

5. Lampe selon la revendication 4, **caractérisée en ce que** la matrice de micromiroirs est segmentée en zones qui peuvent être activées séparément.

6. Lampe selon l'une des revendications précédentes, **caractérisée en ce que** la disposition d'OLED est une disposition d'OLED transparente.

7. Lampe selon l'une des revendications précédentes 1 ou 2, **caractérisée en ce que** la disposition d'OLED est une disposition d'OLED non transparente.

8. Lampe selon l'une des revendications précédentes, **caractérisée en ce que** plusieurs éléments modulant la lumière sont disposés les uns au-dessus des autres sur au moins une phase de la disposition d'OLED.

9. Lampe selon l'une des revendications précédentes, **caractérisée en ce que** différents éléments modulant la lumière sont disposés les uns à côté des autres sur au moins un côté émettant la lumière de la disposition d'OLED.

10. Lampe selon la revendication 6, **caractérisée en ce que** des éléments modulant la lumière sont disposés sur les deux faces de la disposition d'OLED.

11. Lampe selon la revendication 7, **caractérisée en ce que** les éléments modulant la lumière sont différents sur les deux faces.
